# EUROPEAN PATENT APPLICATION

(11) **EP 1 850 390 A2**
(43) Date of publication of application: **31.10.2007**
(21) Application number: 06020940.0
(22) Date of filing: 05.10.2006
(51) Int. Cl.: H01L 27/32

(54) **Display device module**

(30) Priority: 28.04.2006 KR 20060038685
(71) Applicant: LG Electronics Inc., Yongdungpo-gu Seoul 150-010 (KR)
(72) Inventor: Lee, Il Ho, Gumi-shi Gyeongsangbuk-do 730-755 (KR)
(74) Representative: Katérle, Axel

(57) **Abstract**

The present invention discloses the display device module in which the first and second lines can be connected easily to a device-driving unit or a connecting means on which the device-driving unit is mounted, the display device module of the present invention comprises a pixel circuit section including at least one light emitting area, each light emitting area being formed at an overlying area of a substrate between a first electrode and a second electrode on a substrate; at least one first line being electrically connected to the first electrode in the pixel circuit section; at least one second line being electrically connected to the second electrode in the pixel circuit section, wherein each of the first lines and the second lines has a connecting portion formed thereon and the connecting portion is larger than the line in the width, the connecting portions are alternated with the connecting portion(s) of the neighbor line(s) so as to prevent two adjacent connecting portions from being contacted with each other.

## Description

### BACKGROUND OF THE INVENTION

### Field of the Invention

The present invention relates to a display device module, particularly relates to a display device module in which metal wires are effectively arranged on the substrate and contacted easily with an pin or jig.

### Description of the Related Art

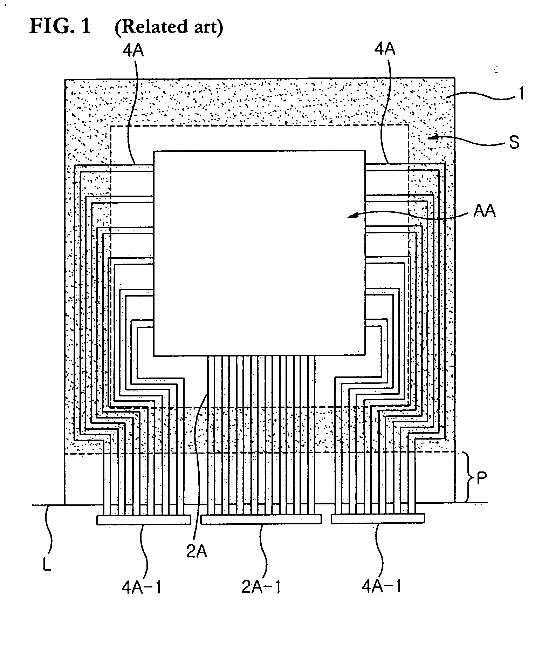

Fig. 1 is a plane view of the conventional organic electroluminescent device comprising a pixel circuit section, the conventional organic electroluminescent device from which a cap is removed is illustrated in Fig. 1 for convenience' sake.

On the other hand, only one of the plurality of pixel circuit sections formed on a mother substrate is illustrated in the shape of the block in Fig. 1, the pixel circuit section **AA** comprises anode electrodes formed on the substrate, an organic electroluminescent light emitting layer formed on the anode electrodes and cathode electrodes formed on the organic electroluminescent light emitting layer.

Data lines **2A** and scan lines **4A** formed on the mother substrate are electrically connected to the anode electrodes and the cathode electrodes (not show) formed in the pixel circuit section **AA,** respectively, and end portions of the data lines **2A** and the scan lines **4A** are concentrated on a portion of the mother substrate **1** to form a pad **P**.

On the other hand, the reference numerals "**4A-1**" and "**2A-1**" which are not illustrated indicate connecting bars (so called as "short bar") formed ends of the scan lines **4A** and the data lines **2A,** a plurality of scan lines **4A** and a plurality of data lines **2A** are connected to each other by the connecting bars **4A-1** and **2A-1**. Also, the reference numeral "**S**" indicates a region on which the cap will be bonded.

The COG (chip on glass) type display device module has been used, in the COG type display device module, a film on which the device-driving unit (IC chip) is mounted is not used for connecting the organic electroluminescent device (hereinafter, referred to as "panel") shown in Fig. 1 and the device-driving unit, the device-driving unit is directly mounted on the substrate on which the pixel circuit section is formed

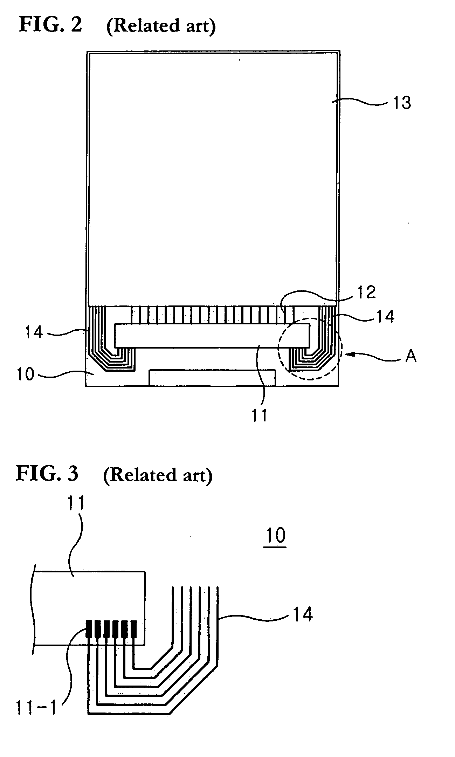

Fig. 2 is a plane view of the COG type organic electroluminescent device module, Fig. 2 shows that a device-driving unit **11** is mounted on a substrate **10.**

The data lines **12** connected electrically the pixel circuit section (although the pixel circuit section is not shown in Fig. 2 by a cap, in below, the reference numeral "**13**" indicates the pixel circuit section for convenience' sake) can be connected directly to the device-driving unit **11.** However, since there is no margin space around the device-driving unit **11,** the scan lines **14** arranged on both sides of the data lines **12** are gone through the both sides of the device-driving unit **11** and then connected to a portion opposite to the portion corresponding to the pixel circuit section **13.**

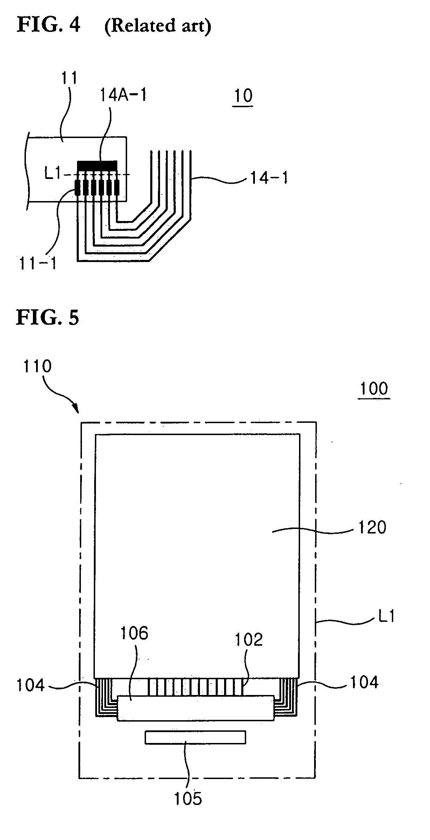

Fig. 3 and Fig. 4 are enlarged views of "**A**" section of Fig. 2 and show a relation between the scan line **14** (**14-1**) and the device-driving unit **11** in the COG type organic electroluminescent device module.

On the other hand, Fig. 3 and Fig. 4 show only a portion of the device-driving unit **11** and a portion of the scan lines **14, 14-1.** Also, the device-driving unit **11** is shown in a transparent state so as to illustrate an arrangement of the scan lines **14** and **14-1.**

As described above, the scan lines **14** gone through the sides of the device-driving unit 11 and connected to a portion of the device-driving unit **11** opposite to the portion corresponding to the pixel circuit section (**13** in Fig. 2) do not have a connecting bar. In this state, an end of respective scan line **14** is connected to a connecting terminal **11-1** (hereinafter, referred to as "bump") formed on the device-driving unit **11** (a state of Fig. 3).

As another structure, the scan lines **14-1** have a connecting bar **14A-1** formed at ends thereof, a portion of each scan line **14-1** is connected to the bump **11-1** of the device-driving unit **11** (a state of Fig. 4).

As shown in Fig. 3, in the state that the connecting bar is not formed on the scan lines **14,** it is difficult to carry out the light inspection and the aging process for the panel.

That is, in the state that the device-driving unit **11** is not mounted on the substrate **10**, it is difficult to contact a pin for the inspection or a jig with all the scan lines **14** separated from each other, one by one.

In addition, due to the jig or the pin contacted with the scan line **14** formed in the shape of a conductive layer with a thin thickness, a scratch can be formed on the scan line **14** or the scan line **14** can be peeled from the substrate **10** (so called as "a peeling phenomenon).

In order to prevent the above problems, the lighting inspection or the aging process is carried out after mounting the device-driving unit **11** on the substrate **10.** However, there is a drawback in that if a result of the inspection or the aging process indicates that the panel is inferior, the expensive device-driving unit **11** should be scrapped along with the panel.

As shown in Fig. **4,** in the state that the scan lines **14-1** are connected to the connecting bar **14A-1,** if the pin for inspection or the jig is contacted with only one scan line **14-1,** a signal is transmitted to all the scan lines **14-1** via the connecting bar **14A-1.** Accordingly, although the device-driving unit **11** is not mounted on the substrate **10,** it is possible to carry out the lighting inspection and the aging process.

In this structure, however, after completing the lighting inspection and the aging process, the connecting bar **14A-1** formed on the substrate **10** should be separated from the scan lines **14-1** prior to mounting the device-driving unit **11.** In order to achieve the above purpose, a laser scribing process is additionally performed to cut the scan lines **14-1** along a scribe line **L1.**

In the above description regarding Fig. 3 and Fig. 4, although only a structure and arrangement of the scan lines **14** and **14-1** are described, respective data line **12** connected to the device-driving unit **11** has the same structure and function. Accordingly, the description thereon is emitted below.

### SUMMARY OF THE INVENTION

The present invention is conceived to solve the above problems generated in the display device module in which the device-driving unit is mounted on the substrate, an object of the present invention is to provide the display device module in which the first and second lines can be connected easily to a device-driving unit or a connecting means on which the device-driving unit is mounted.

Another object of the present invention is to provide the display device module which can prevent the first and second lines from being damaged by contact between the line and a test pin or jig.

In order to achieve the above objects, a display device module according to the present invention comprises a pixel circuit section including at least one light emitting area, each light emitting area being formed at an overlying area of a substrate between a first electrode and a second electrode on a substrate; at least one first line being electrically connected to the first electrode in the pixel circuit section; at least one second line being electrically connected to the second electrode in the pixel circuit section, wherein each of the first lines and the second lines has a connecting portion formed thereon and the connecting portion is larger than the line in the width.

The connecting portions are alternated with the connecting portion(s) of the neighbor line(s) so as to prevent two adjacent connecting portions from being contacted with each other.

The display device module according to the present invention further comprises an insulating layer formed on a portion of the substrate including a connecting portion of each line, the insulating layer has openings formed thereon corresponding to the connecting portions.

Here, the connecting portion has a plane surface which is on the same level with that of the insulating layer, and the connecting portion is formed such that a portion of the connecting portion is protruded from the insulating layer through the opening.

In addition, the display device module according to the present invention comprises a device driving unit mounted on the substrate area and being electrically connected to the first and second lines through the connecting portions.

Further, the display device module according to the present invention further comprises a connecting means mounted on the substrate and being electrically connected to the first and second lines to a device driving unit installed outside of the substrate, the connecting means is a film on which the device driving unit is mounted.

### BRIEF DESCRIPTION OF THE DRAWINGS

These and other features, aspects and advantages of the present invention will become better understood with regard to the following description, appended claims, and accompanying drawings wherein:

Fig. 1 is a plane view of the conventional organic electroluminescent device on which a cap is not bonded;

Fig. 2 is a plane view of the COG type organic electroluminescent device module;

Fig. 3 and Fig. 4 are enlarged views of "A" section of Fig. 2 and show an arrangement of the scan lines in the COG type organic electroluminescent device module;

Fig. 5 is a plane view of the COG type organic electroluminescent device module according to the present invention;

Fig. 6 is a view showing an arrangement of the scan lines on a device driving unit-mounting area of a substrate; and

Fig. 7 is a view showing an arrangement of the data lines on a device driving unit-mounting are of a substrate.

### DETAILED DESCRIPTON OF THE INVENTION

Hereinafter, the preferred embodiments of the present will be described in detail with reference to the accompanying drawings. In the following embodiments, the organic electroluminescent device is provided as an example of the light emitting device. It is, however, obvious that the teaching of the present invention is not limited to the organic electroluminescent device.

The organic electroluminescent device (hereinafter, referred to as "panel") comprises at least one light emitting area formed by at least one anode electrode ("first electrode") formed on the substrate, an organic electroluminescent light emitting layer formed on the anode electrodes and at least one cathode electrode ("second electrode")formed on the organic electroluminescent light emitting layer. Here, an order for forming the cathode electrodes and the anode electrodes can be opposed to that for forming the above structure.

On the other hand, the substrate on which the above elements are provided can be made of the various material including conductive material and nonconductive material such as plastic film, silicon, glass and the like. The conductive material can act as transistor in the active type organic electroluminescent device.

Fig. 5 is a plane view of the COG type organic electroluminescent device module according to the present invention, Fig. 5 shows data lines ("first lines") **102**, scan lines ("second lines") **104** and a pixel circuit section including the anode electrodes, the organic electroluminescent light emitting layer and the anode electrodes.

In Fig. 5, on the other hand, the pixel circuit section is not shown by a cap. Hereinafter, for the convenience' sake, the reference numeral "**120**" indicates the pixel circuit section.

Also, the reference numeral "**110**" in Fig. 5 indicated the "panel" on which the device-driving unit is not mounted, and the reference numeral "**L1**" is a scribed line along the module is individualized.

As shown in Fig. 5, a specific area **106** is provided on a region adjacent to the pixel circuit section **120,** a device-driving unit (or a connecting means) is mounted on the area **106** (hereinafter, referred to as "mounting area") and electrically connected to the data lines **102** and the scan lines **104.** Another specific area **105** is formed on a region adjacent to the mounting area **106,** a flexible printed circuit board supplying an electrical signal to the device-driving unit is mounted the above area **105.**

The data lines **102** connected electrically to the anode electrodes in the pixel circuit section **120** can be extended directly to the mounting area **106.** However, the scan lines **104** connected electrically to the cathode electrodes are extended to both sides of the mounting area **106,** and a portion of each scan line **104** formed on the mounting area **106** is then electrically connected to the device-driving unit which will be mounted later.

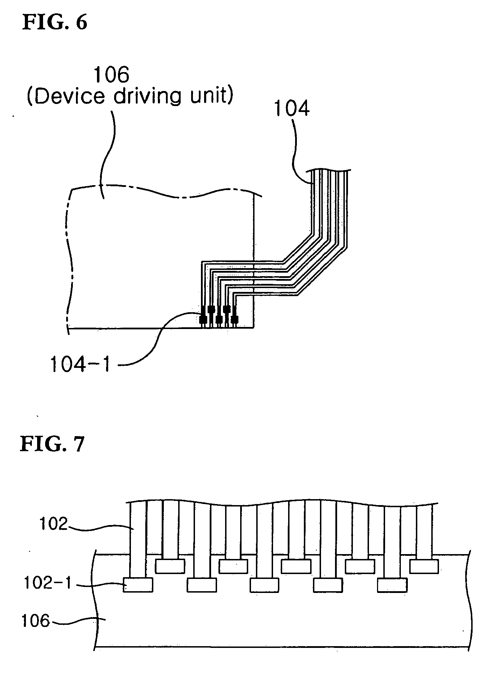

Fig. 6 is a view showing an arrangement of the scan lines **104** on the mounting area 106. In Fig. 6, the reference numeral "**106**" indicates the mounting area on which the device-driving unit, but can be regarded as the device driving unit mounted the mounting area.

As mentioned previously, in the present invention, the scan lines **104** are extended through both sides of the mounting area **106.**

As shown in Fig. 6, the scan lines **104** extended from one side of the pixel circuit section **120** are extended to the mounting area **106** through one side of the mounting area **106.** On the other hand, a connecting portion **104-1** is formed on a portion of respective scan line **104** arranged on the disposed on the mounting area **106,** this connecting portion is electrically connected to a connecting portion (bump) formed on the device-driving unit (a driving IC chip).

The connecting portion **104-1** formed on each scan line **104** has a larger width than that of the scan line **104** such that the connecting portion **104-1** of each scan line is contacted precisely with the bump of the device driving unit.

In particular, the connecting portion **104-1** of one scan line **104** is alternated with the connecting portion(s) of the neighbor scan line(s) to prevent two adjacent connecting portions from being contacted with each other. At this time, a location of the connecting portion **104-1** of respective scan line **104** is determined according to a location of the bump of the device driving unit, and so a location of the connecting portion **104-1** of respective scan line **104** is determined after considering the above condition when the device driving unit is designed.

Although Fig. 6 shows that the scan lines **104** are disposed concentratively on only one portion of one side of the mounting area **106,** the present invention is not limited thereto. That is, the scan lines **104** can be disposed uniformly through an entire area of one side of the mounting area **106.**

Also, if the connecting portion **104-1** of respective scan line **104** is placed in the mounting area **106,** the connecting portion **104-1** can perform its function regardless of its location.

Fig. 7 is a view showing an arrangement of the data lines **102** on the mounting area **106** are of the substrate.

As shown in Fig. 7, the data lines **102** connected electrically to the anode electrodes of the pixel circuit section **120** are extended in the mounting area **106** through one side of the mounting area **106,** respective data line **102** has a connecting portion **102-1** formed on a portion disposed on the mounting area **106.** The connecting portion **102-1** is contacted with the connecting portion (bump) of the device driving unit (a driving IC chip).

The connecting portion **102-1** of respective data line **102** has a larger width than that of the data line **102** in order to obtain an accurate contact between each connecting portion of the data line **102** and a bump of the device driving unit.

Also, the connecting portion **102-1** of respective data line **102** is alternated with the connecting portion(s) of the neighbor data line(s) to prevent two adjacent connecting portions from being contacted with each other.

In the structure shown in Fig. 6 and Fig. 7, on the other hand, an insulating layer is formed on the substrate **100** including data lines **102** and the scan lines **104** extended on the mounting area **106.** This insulating layer has openings corresponding to the connecting portions **102-1** and **104-1** formed on the data lines **102** and the scan lines **104,** and so the connecting portions **102-1** and **104-1** are exposed to an exterior through the openings of the insulating layer.

Due to such structure, the bumps of the device-driving unit mounted on the mounting area **106** are not contacted with the areas of the data lines **102** and the scan lines **104** except the connecting portions **102-1** and **104-1.**

On the other hand, if surfaces of the connecting portions **102-1** and **104-1** placed in the openings of the insulating layer are located below a surface of the insulating layer, the bumps of the device driving unit are not contacted with the connecting portions **102-1** and **104-1** of the data line **102** and the scan lines **104** by the insulating layer.

In order to secure an accurate contact between respective bump of the device driving unit and respective connecting portion **102-1** (and **104-1**), at least surfaces of the connecting portions **102-1** and **104-1** of the data lines **102** and the scan lines **104** should be leveled with a surface of the insulating layer. Accordingly, a height (thickness) of the respective connecting portion **102-1** (and **104-1**) should be the same as or a higher than that of the insulating layer.

On the other hand, an integration degree of the device is increased and a size of the device is reduced, and so a size of the device driving unit is reduced. Accordingly, a space in which the device driving unit is contacted with the lines (the data line and the scan lines) is insufficient so that it is difficult to increase a width of the connecting portion **102-1** (and **104-1**) of the lines. In such conditions, by increasing a height (thickness) of the connecting portion **102-1** (and **104-1**), an electrical characteristic is enhanced and the various inspections can be performed easily.

In the present invention, the connecting portions **102-1** and **104-1** can be formed integrally with the data lines **102** and the scan lines **104.** However, respective connecting portion can be a conductive layer which is formed separately on respective line **102** (or **104**) through a separate process and made of material with a resistance smaller than that of the respective line **102** (or **104**) (that is, high electrical conductivity). Also, the connecting portion **102-1** and **104-1** can have the single-layered structure or the multiple-layered structure.

A functional characteristic of the organic electroluminescent device module according to the present invention having the structure as described above will be illustrated with reference to the drawings.

After the panels **110** shown in Fig. 5 are formed on the substrate **100,** the lighting inspection for verifying whether the panel **110** is operated normally or not and the aging process in which the severe conditions are applied to the panel **110** are carried out.

In the lighting inspection and the aging process, jigs or a pins of the test equipment for applying the signal are contacted with the data line **102** and the scan line **104,** in particular, the connecting portions **102-1** and **104-1** formed on the mounting area **106,** the signal is then applied.

Here, since respective connecting portion **102-1** (and **104-1**) has an area (width) larger than that of the data line **102** (and the scan line **104**), the pin or the jig for applying the signal can be contacted easily with the respective connecting portion **102-1** (and **104-1**). Also, if the jig or the pin having a relatively large width is used, the jig or the pin can be contacted simultaneously with all the connecting portions **102-1** (or **104-1**), and the electrical signal can be applied to all the data lines **102** (or the scan lines **104**) at once.

Electrical signal is transmitted to the anode electrodes and the cathode electrodes via the data lines **102** and the scan lines **104.**

In the above description, on the other hand, the COG (chip on glass) type display device module in which the device driving unit is directly mounted on the mounting area **106** in the substrate **100** is illustrated as an example, however, the present invention is not limited thereto.

As another embodiment, a connecting means is mounted on the mounting area 106 for connecting electrically the device driving unit and the data lines 102 (and the scan lines 104). That is, a film on which the device driving unit (IC chip) is mounted is attached to the mounting area **106** of the substrate **100** and the film acting as the connecting means is then electrically connected to the data lines **102** and the scan lines **104** through the connecting portions **102-1** and **104-1** to obtain the COF (chip on film) type display device module.

In the display device module according to the present invention as described, due to the structure in which the connecting bar is not formed at ends of scan lines (and the data lines), there is no need to carry out the laser scribing process for removing the connecting bar when the scribing process for individualizing the device module is performed.

In particular, although the connecting bars are not formed at ends of the scan lines and the data lines, the connecting portion having a relatively large area is formed on an end portion of respective data line (and scan line) so that the pin for the inspection or the jig can be contacted easily with the connecting portion. Also, the scan lines and the data lines are electrically connected to the device driving unit through the connecting portions having a relatively large area, and so the resistance can be minimized.

In addition, since the scan lines and the data lines are covered with the insulating layer and the connecting portions formed at the scan lines and the data lines are exposed through the openings of the insulating layer, the scan lines and the data lines are not damaged and peeled from the substrate although the inspection pin or the jig is contacted with the connecting portions. Further, any scratch is not formed on the data lines and the scan lines by the insulating layer formed on the lines.

The preferred embodiments of the present invention have been described for illustrative purposes, and those skilled in the art will appreciate that various modifications, additions, and substitutions are possible, without departing from the scope and spirit of the present invention as disclosed in the accompanying claims.

## Claims

1. A display device module comprising:
a pixel circuit section including at least one light emitting area, each light emitting area being formed at an overlying area of a substrate between a first electrode and a second electrode on a substrate;
at least one first line being electrically connected to the first electrode in the pixel circuit section;
at least one second line being electrically connected to the second electrode in the pixel circuit section, wherein each of the first lines and the second lines has a connecting portion formed thereon and the connecting portion is larger than the line in the width.

2. The display device module of claim 1, further comprising a device driving unit mounted on the substrate and being electrically connected to the first and second lines through the connecting portions.

3. The display device module of claim 1, further comprising a connecting means bonded to the substrate and being electrically connected to the first and second lines through the connecting portions.

4. The display device module of claim 3, wherein the connecting means is a film on which a device driving unit is mounted.

5. The display device module of claim 1, wherein the connecting portions are alternated with the connecting portion(s) of the neighbor line(s) so as to prevent two adjacent connecting portions from being contacted with each other.

6. The display device module of claim 1, further comprising an insulating layer formed on a portion of the substrate including a portion of each line, the insulating layer having openings formed thereon corresponding to the connecting portions of the lines to expose the connecting portions.

7. The display device module of claim 6, wherein the connecting portion has a surface which is on the same level with that of the insulating layer.

8. The display device module of claim 6, wherein the connecting portion is protruded from the insulating layer.

9. The display device module of claim 1, wherein the connecting portion is formed integrally with the line.

10. The display device module of claim 1, wherein the connecting portion is a conductive layer formed on the line.

11. The display device module of claim 10, wherein the connecting portion is made of material with a resistance which is smaller than that of the line.

12. The display device module of claim 2, wherein the second line are extended through sides of the device-driving unit except a side corresponding to the first line.

13. The display device module of claim 12, wherein the second lines are uniformly disposed over the entire sides of the device-driving unit connecting area except the side corresponding to the first lines.

14. The display device module of claim 1, wherein, the pixel circuit unit comprises an anode electrode formed on the substrate, an organic light-emitting layer formed on the anode electrode, and a cathode electrode formed on the organic light-emitting layer, the first electrode is the anode electrode and the second electrode is the cathode electrode.

15. A display device module comprising:
a pixel circuit section including at least one light emitting area, each light emitting area being formed at an overlying area of a substrate between a first electrode and a second electrode on a substrate;
at least one first line being electrically connected to the first electrode in the pixel circuit section; and
at least one second line being electrically connected to the second electrode in the pixel circuit section; wherein each of the first line and the second line has a connecting portion formed thereon, the connecting portion is larger than the line in the width, and the connecting portions are alternated with the connecting portion(s) of the neighbor line(s) so as to prevent two adjacent connecting portions from being contacted with each other.

16. The display device module of claim 15, wherein the connecting portion is larger than the line in the width.

17. The display device module of claim 15, further comprising a device driving unit mounted on the substrate and being electrically connected to the first and second lines through the connecting portions.

18. The display device module of claim 15, further comprising a connecting means bonded to the substrate and being electrically connected to the first and second lines through the connecting portions.

19. The display device module of claim 18, wherein the connecting means is a film on which a device driving unit is mounted.
